# FASCICULE DE BREVET EUROPEEN

(11) **EP 1 642 388 B1**
(45) Date de publication et mention de la délivrance du brevet: **13.12.2006**
(21) Numéro de dépôt: 04767593.9
(22) Date de dépôt: 06.07.2004
(51) Int. Cl.: H03K 19/21

(54) **DISPOSITIF DE COMPARAISON DE DEUX MOTS DE N BITS CHACUN**
EINRICHTUNG ZUM VERGLEICHEN ZWEIER WÖRTER VON JEWEILS N BIT
DEVICE FOR COMPARING TWO WORDS OF N BITS EACH

(30) Priorité: 08.07.2003 FR 0308360
(43) Date de publication de la demande: 05.04.2006
(73) Titulaire: ATMEL NANTES SA, 44306 Nantes Cédex 3 (FR)
(72) Inventeur: COLOMA, Bernard, F-44300 Nantes (FR)
(74) Mandataire: Guéné, Patrick Lucien Juan Joseph
(86) Numéro de dépôt international: PCT/FR2004/001758
(87) Numéro de publication internationale: WO 2005/006557

(56) Documents cités:
- EP-A- 0 939 490
- US-A- 6 014 074
- US-A1- 2002 083 108

## Description

L'invention concerne un dispositif de comparaison de deux mots (bus) N et P de n bits chacun. Il peut notamment, mais non exclusivement être réalisé sous la forme d'un circuit à base de transistors MOS.

Le comparateur selon l'invention peut être utilisé dans n'importe quel type de circuit nécessitant une comparaison de deux bus de n bits.

Traditionnellement, la comparaison de deux mots est faite à partir d'un soustracteur à propagation de retenue. La soustraction se fait bit à bit. La retenue se propage en série de bit à bit.

Un inconvénient de cette solution connue est que plus le nombre de bits des mots à comparer est élevé, plus la soustraction prend du temps.

Un autre inconvénient de cette solution connue est qu'elle est lente et demande un nombre important de transistors.

Il a par ailleurs été proposé dans US 2002 083 108 A1 par exemple, d'utiliser un soustracteur parallèle afin de diminuer le temps de propagation de la retenue. L'inconvénient de cette variante est qu'elle augmente considérablement la complexité du circuit, c'est-à-dire le nombre de transistors.

L'invention a notamment pour objectif de pallier ces différents inconvénients de l'état de la technique.

Plus précisément, l'un des objectifs de la présente invention est de fournir un dispositif de comparaison rapide.

Un autre objectif de l'invention est de fournir un dispositif de comparaison modulable et toujours performant quel que soit le nombre de bits des mots à comparer.

Un objectif complémentaire de l'invention est de fournir un dispositif de comparaison performant et économique en nombre de transistors.

Ces différents objectifs, ainsi que d'autres qui apparaîtront par la suite, sont atteints selon l'invention à l'aide d'un dispositif de comparaison de deux mots N et P de n bits chacun, ledit dispositif comprenant au moins un bloc comparateur de niveau 1 comprenant lui-même :
- n blocs comparateur de base, permettant chacun de comparer les bits Ni et Pi de rang i des mots N et P, avec i compris entre 0 et n-1, et comprenant chacun :
   * un premier sous-bloc permettant de générer sur sa sortie, formant une première sortie (OUT_XORi) du bloc comparateur de base, un premier signal indiquant si les bits Ni et Pi sont égaux ou non ;
   * un second sous-bloc permettant de générer sur sa sortie un second signal indiquant lequel des bits Ni et Pi est le plus grand ;
   * un troisième sous-bloc permettant de laisser passer le second signal sur une seconde sortie (SOUTi) du bloc comparateur de base, si le premier signal n'indique pas une égalité des bits Ni et Pi, et de bloquer le second signal dans le cas contraire ;
- des moyens de génération d'un troisième signal sur une première sortie (OUT_XOR4_b) du bloc comparateur de niveau 1, indiquant que les nombres N et P sont égaux si les n premiers signaux indiquent que les n bits Ni et les n bits Pi sont égaux, et indiquant que les nombres N et P ne sont pas égaux dans le cas contraire ;
- des premiers moyens de passage sélectif, permettant de relier sélectivement à une seconde sortie (OUT_COMP4) du bloc comparateur de niveau 1 la seconde sortie (SOUTi) d'un bloc comparateur de base qui, parmi les blocs comparateurs de base ayant un second signal sur leur seconde sortie, traite des bits de plus fort poids, le signal présent sur la seconde sortie du bloc comparateur de niveau 1 indiquant lequel des nombres N et P est le plus grand.

Le principe général de l'invention consiste donc à ne pas utiliser de moyens de soustraction mais uniquement des moyens de comparaison. En effet, chaque bloc comparateur de base fournit deux signaux utilisés par le bloc comparateur de niveau 1 : l'un indiquant l'égalité ou non entre deux bits, et l'autre indiquant lequel des deux bits est le plus grand. De même, chaque bloc comparateur de niveau 1 fournit deux signaux : l'un indiquant l'égalité ou non entre deux groupes de bits, et l'autre indiquant lequel des deux groupes de bits est le plus grand.

Comme expliqué par la suite, dans un mode de réalisation particulier de l'invention, les signaux fournis par une pluralité de blocs comparateur de niveau 1 sont utilisés par un bloc comparateur de niveau 2. Plus généralement, il est possible de prévoir plusieurs niveaux de blocs comparateur : chaque bloc comparateur de niveau k-1 fournissant deux signaux destinés à être utilisés par un bloc comparateur de niveau k : l'un indiquant l'égalité ou non entre deux groupes de bits, et l'autre indiquant lequel des deux groupes de bits est le plus grand.

Pour deux mots de n bits, le principe de calcul est le suivant : en partant des poids forts, dès qu'un bit Pi (i compris entre 0 et n-1) est différent d'un bit Ni (i compris entre 0 et n-1) alors un des deux nombres est plus grand que l'autre. Ainsi si Ni est égal à 1 et Pi à 0 alors N est plus grand que P, sinon si Pi est égal à 1 et Ni à 0 alors P est plus grand que N.

L'originalité de l'invention est d'utiliser une structure de base (bloc comparateur de base) contenant peu de transistors et permettant un temps de propagation très faible. Cette structure va être répétée n fois et interconnectée par des moyens spécifiques pour constituer un bloc comparateur (de niveau 1) n bits. Comme expliqué ci-après, dans un mode de réalisation préférentiel de l'invention, plusieurs blocs comparateur de niveau 1 peuvent fonctionner très rapidement, en parallèle et de manière totalement autonome, reliés entre eux par des moyens spécifiques, permettant ainsi de comparer des mots ayant un nombre de bits important.

Avantageusement, le premier sous-bloc comprend une porte « OU exclusif » recevant en entrée les bits Ni et Pi.

De façon avantageuse, le second sous-bloc comprend une porte « OU » recevant en entrée le bit Pi et, via un inverseur, le bit Ni.

Avantageusement, le troisième sous-bloc comprend une porte « de passage sélectif » dont l'entrée est reliée à la sortie du second sous-bloc et qui est commandée par la sortie du premier sous-bloc.

Selon une caractéristique avantageuse, les moyens de génération du troisième signal, sur la première sortie du bloc comparateur de niveau 1, comprennent une porte « OU » dont les entrées sont reliées aux premières sorties des blocs comparateur de base.

Préférentiellement, les premiers moyens de passage sélectif comprennent :
- des moyens permettant de relier la seconde sortie du bloc comparateur de base traitant les bits de poids forts Nn-1 et Pn-1 à la seconde sortie du bloc comparateur de niveau 1, de façon directe ;
- pour chacun des autres blocs comparateur de base traitant des bits Nj et Pj, avec j compris entre 0 et n-2, des moyens permettant de relier la seconde sortie du bloc comparateur de base à la seconde sortie du bloc comparateur de niveau 1, via une porte « de passage sélectif » commandée par la sortie d'une porte « OU » dont les entrées sont reliées aux premières sorties des blocs comparateur de base de poids supérieur à j.

Dans un mode de réalisation avantageux de l'invention, ledit au moins un bloc comparateur de niveau 1 comprend en outre des moyens de mémorisation de la valeur présente sur la seconde sortie du bloc comparateur de niveau 1.

De façon préférentielle, les moyens de mémorisation comprennent :
- une porte « NON OU » dont une première entrée est reliée à la seconde sortie du bloc comparateur de niveau 1 et une seconde entrée est reliée, via un inverseur, à la première sortie du bloc comparateur de niveau 1 ;
- un inverseur faible courant reliant la sortie de ladite porte « NON OU » à la première entrée de ladite porte « NON OU ».

Dans un mode de réalisation particulier de l'invention, le dispositif comprend au moins un bloc comparateur de niveau 2 comprenant lui-même :
- q blocs comparateur de niveau 1, avec q ≥ 2, comprenant chacun une partie des n blocs comparateur de base ;
- des moyens de génération d'un quatrième signal sur une première sortie du bloc comparateur de niveau 2, indiquant que les nombres N et P sont égaux si les premières sorties des q blocs comparateur de niveau 1 indiquent que les bits qu'ils comparent sont égaux, et indiquant que les nombres N et P ne sont pas égaux dans le cas contraire ;
- des seconds moyens de passage sélectif, permettant de relier sélectivement à une seconde sortie du bloc comparateur de niveau 2 la seconde sortie d'un bloc comparateur de niveau 1 qui, parmi les blocs comparateurs de niveau 1 ayant un second signal sur leur seconde sortie, traite des bits de plus fort poids, le signal présent sur la seconde sortie du bloc comparateur de niveau 2 indiquant lequel des nombres N et P est le plus grand.

Ainsi, pour améliorer la vitesse de traitement, on utilise un mode de comparaison parallèle. Pour comparer deux mots de n bits, N et P, on décompose le comparateur en plusieurs blocs comparateur de niveau 1 fonctionnant en parallèle. Le découpage peut se faire sur des blocs de 4 bits maximum, mais aussi sur des blocs de 2 bits, 3 bits, 5 bits ou plus. Le découpage par 4 est plus intéressant en terme de nombre de transistors et de rapidité pour des bus de format 8, 16, 32, 40...

Avantageusement, les moyens de génération du quatrième signal, sur la première sortie du bloc comparateur de niveau 2, comprennent une porte « OU » dont les entrées sont reliées aux premières sorties des blocs comparateur de niveau 1.

De façon avantageuse, les seconds moyens de passage sélectif comprennent :
- des moyens permettant de relier la seconde sortie du bloc comparateur de niveau 1 traitant les bits de poids forts à la seconde sortie du bloc comparateur de niveau 2, via une porte « de passage sélectif » commandée par la première sortie du bloc comparateur de niveau 1 traitant les bits de poids forts ;
- pour chacun des autres blocs comparateur de niveau 1, des moyens permettant de relier la seconde sortie du bloc comparateur de niveau 1 à la seconde sortie du bloc comparateur de niveau 2, via une porte « de passage sélectif » commandée par la sortie d'une porte « OU » dont une entrée est reliée, via un inverseur, à la première sortie dudit bloc comparateur de niveau 1, et dont les autres entrées sont reliées aux premières sorties des blocs comparateur de niveau 1 de poids supérieur.

Avantageusement, ledit au moins un bloc comparateur de niveau 2 comprend en outre des moyens de mémorisation de la valeur présente sur la seconde sortie du bloc comparateur de niveau 2.

Selon une caractéristique avantageuse, les moyens de mémorisation comprennent :
- une porte « NON OU » dont une première entrée est reliée à la seconde sortie du bloc comparateur de niveau 2 et une seconde entrée est reliée, via un inverseur, à la première sortie du bloc comparateur de niveau 2 ;
- un inverseur faible courant reliant la sortie de ladite porte « NON OU » à la première entrée de ladite porte « NON OU ».

Dans un mode de réalisation particulier de l'invention, le dispositif comprend au moins un bloc comparateur de niveau k, avec k ≥ 2, comprenant lui-même :
- p blocs comparateur de niveau k-1, avec p ≥ 2 ;
- des moyens de génération d'un cinquième signal sur une première sortie du bloc comparateur de niveau k, indiquant que les nombres N et P sont égaux si des premières sorties des p blocs comparateur de niveau k-1 indiquent que les bits qu'ils comparent sont égaux, et indiquant que les nombres N et P ne sont pas égaux dans le cas contraire ;
- des troisièmes moyens de passage sélectif, permettant de relier sélectivement à une seconde sortie du bloc comparateur de niveau k la seconde sortie d'un bloc comparateur de niveau k-1 qui, parmi les blocs comparateurs de niveau k-1 ayant un signal sur leur seconde sortie, traite des bits de plus fort poids, le signal présent sur la seconde sortie du bloc comparateur de niveau k indiquant lequel des nombres N et P est le plus grand.

Avantageusement, chaque porte « de passage sélectif » comprend un transistor N monté en parallèle avec un transistor P.

Selon une caractéristique avantageuse, le dispositif est réalisé sous la forme d'un circuit câblé.

D'autres caractéristiques et avantages de l'invention apparaîtront à la lecture de la description suivante d'un mode de réalisation préférentiel de l'invention, donné à titre d'exemple indicatif et non limitatif, et des dessins annexés, dans lesquels :
- la figure 1 présente un schéma d'un bloc comparateur de base (bloc comparateur 1 bit), compris dans un comparateur 8 bits selon un mode de réalisation particulier de l'invention ;
- la figure 2 présente un schéma d'un bloc comparateur de niveau 1 (bloc comparateur 4 bits), compris dans un comparateur 8 bits selon un mode de réalisation particulier de l'invention ;
- la figure 3 présente un schéma d'un comparateur 8 bits selon un mode de réalisation particulier de l'invention ;
- la figure 4 présente des moyens (optionnels) de mémorisation de la valeur présente sur la seconde sortie (OUT_COMP4) du bloc comparateur de niveau 1 (bloc comparateur 4 bits) de la figure 2.

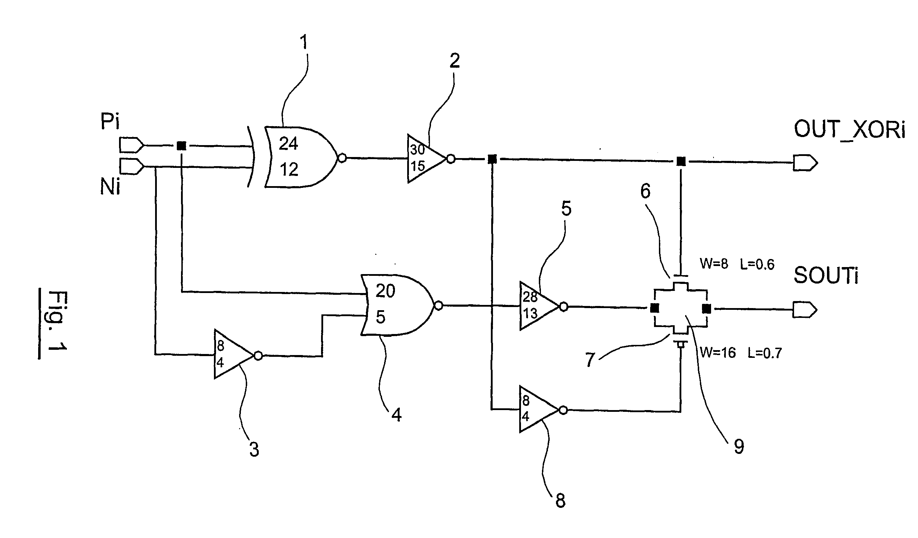

On présente maintenant, en relation avec la **figure 1,** un bloc comparateur de base (bloc comparateur 1 bit).

Ce bloc reçoit en entrée deux bits Ni et Pi à comparer (bits de rang i des mot N et P). Il présente deux sorties : l'une (OUT_XORi) indique si les deux bits Ni et Pi sont égaux, l'autre (SOUTi) indique lequel des deux bits Ni et Pi est le plus grand.

Il comprend :
- un premier sous-bloc comprenant une porte « OU exclusif » (XOR), recevant en entrée les bits Ni et Pi et dont la sortie constitue la première sortie OUT_XORi du bloc comparateur 1 bit. Cette porte XOR est elle-même constituée d'une porte « Non OU exclusif » (NXOR) 1 suivie d'un inverseur 2 ;
- un second sous-bloc comprenant une porte « OU » (OR) recevant en entrée le bit Pi et, via un inverseur 3, le bit Ni. Cette porte OR est elle-même constituée d'une porte « Non OU » (NOR) 4 suivie d'un inverseur 5 ;
- un troisième sous-bloc comprenant une porte de passage sélectif (« pass-gate ») 9 dont l'entrée est reliée à la sortie du second sous-bloc (c'est-à-dire à l'inverseur référencé 5) et dont la sortie constitue la seconde sortie SOUTi du bloc comparateur 1 bit. Cette porte de passage sélectif est commandée par la première sortie OUT_XORi du bloc comparateur 1 bit. En effet, elle comprend un transistor N 6 monté en parallèle avec un transistor P 7, qui activés par la première sortie OUT_XORi, directement ou via un inverseur 8 respectivement.

On détaille maintenant le fonctionnement de ce bloc comparateur 1 bit. Le premier sous-bloc 1, 2 permet de savoir si les deux bits (Ni et Pi) sont égaux ou pas. Ensuite la porte de passage 9, commandée par la sortie du premier sous-bloc 1, 2 (OU exclusif) permet, soit de transmettre le résultat de la comparaison si Ni est différent de Pi, soit de mettre le signal de sortie SOUTi en haute impédance (porte de passage bloquée pour Ni égale à Pi). Ainsi lorsque :
- Ni = Pi, alors OUT_XORi = 0 et SOUTi est HZ (haute impédance) ;
- Pi = 1 et Ni = 0 alors OUT_XORi = 1 et SOUTi = 1 ;
- Pi = 0 et Ni = 1 alors OUT_XORi = 1 et SOUTi = 0.

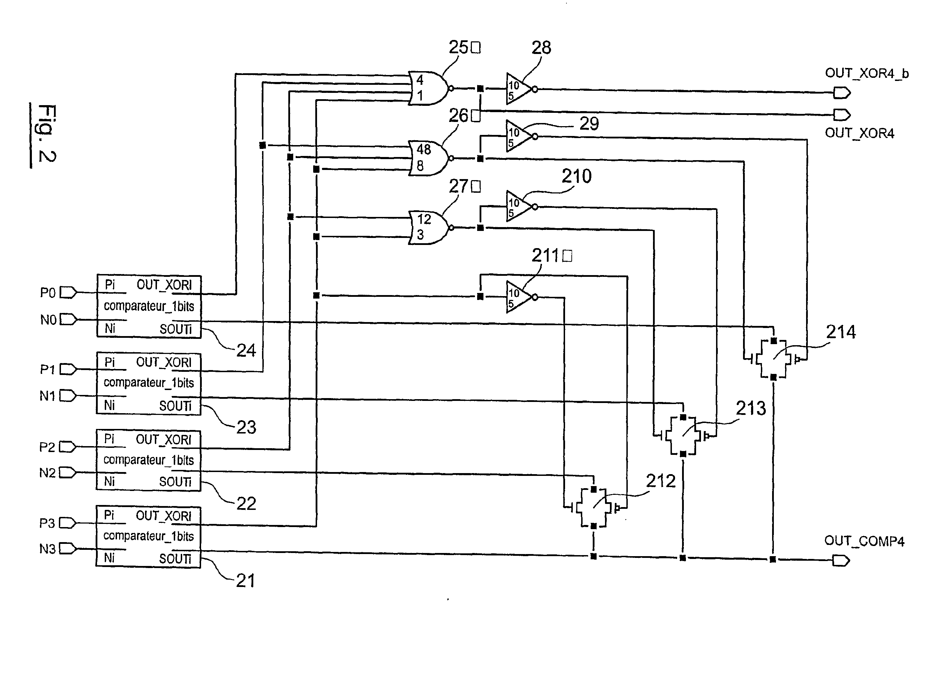

On présente maintenant, en relation avec la **figure 2,** un bloc comparateur de niveau 1 (bloc comparateur 4 bits).

Ce bloc reçoit en entrée un bus d'entrée N de 4 bits (N3, N2, N1, N0) et un bus d'entrée P de 4 bits (P3, P2, P1, P0), N et P étant des mots de 4 bits à comparer.

Il présente trois sorties :
- la sortie OUT_XOR4_b, qui est active à 0 et indique si les deux nombres de 4 bits sont égaux ;
- la sortie OUT_XOR4, qui est l'inverse de la sortie OUT_XOR4_b. Elle est donc active à 1 et indique si les deux nombres de 4 bits sont égaux ;
- la sortie OUT_COMP4, qui indique le résultat de la comparaison des deux nombres de 4 bits (c'est-à-dire lequel des deux est le plus grand).

Il comprend :
- quatre blocs comparateur 1bit référencés 21 à 24 ;
- trois portes « Non OU » (NOR) référencées 25 à 27 ;
- quatre inverseurs référencés 28 à 211 ;
- trois portes de passage sélectif référencées 212 à 214.

La porte NOR référencée 25 et l'inverseur référencé 28 qui la suit forment ensemble une porte « OU » (OR), recevant en entrée les sorties OUT_XORi des quatre blocs comparateur 1bit. La sortie de cette porte OR constitue la sortie OUT_XOR4_b du bloc comparateur 4 bits. La sortie OUT_XOR4 du bloc comparateur 4 bits correspond directement à la sortie de la porte NOR référencée 25.

La sortie SOUTi du bloc comparateur 1 bit référencé 21, qui traite les bits de poids forts N3 et P3, est reliée directement à la sortie OUT_COMP4 du bloc comparateur 4 bits.

La sortie SOUTi de chacun des autres blocs comparateur 1 bit référencés 22 à 24, qui traitent des bits Nj et Pj (avec j compris entre 0 et n-2), est reliée à la sortie OUT_COMP4 du bloc comparateur 4 bits, via une des portes « de passage sélectif » 212 à 214. Chacune de ces portes « de passage sélectif » est commandée par un « OU » (réalisé avec l'une des portes NOR 26, 27 et l'inverseurs 29, 210 qui la suit, ou bien par le seul inverseur référencé 211) des sorties OUT_XORi des blocs comparateur 1 bit de poids supérieur.

On détaille maintenant le fonctionnement de ce bloc comparateur 4 bits. En partant des poids forts, dès que la sortie OUT_XORi d'un bloc comparateur 1bit est différente de 0, c'est-à-dire qu'un bit Pi est différent d'un bit Ni, alors un des deux nombres N et P est plus grand que l'autre. A ce moment, la comparaison est terminée. On peut détecter suivant la valeur de SOUTi (du bloc comparateur 1bit dont la sortie OUT_XORi est différente de 0) lequel des deux nombres N et P est le plus grand. Il n'est donc pas nécessaire de tenir compte des blocs de comparaison 1 bit suivants (de poids plus faible). Il est même nécessaire de bloquer leurs sorties (qui fausseraient la comparaison). Pour cela, il faut bloquer les portes de passages 212 à 214 reliant les sorties SOUTi des comparateur 1 bit de poids inférieurs à la sortie OUT_COMP4. Ces portes de passage sont commandées par un OU des sorties OUT_XORi des blocs comparateur 1bit de poids supérieur. Ainsi, en partant des poids forts, dès qu'une sortie OUT_XORi d'un bloc comparateur 1bit est égale à 1, elle positionne à 0 toutes les sorties des portes NOR reliées aux sorties OUT_XORi de poids inférieurs. Les sorties des portes NOR bloquent ainsi les portes de passage reliant les sortie SOUTi des comparateurs 1bit de poids inférieurs à la sortie OUT_COMP4.

Lorsque les quatre bits de N sont identiques aux quatre bits de P, les deux nombres de quatre bits sont alors identiques. Un OU des quatre sorties OUT_XORi des quatre comparateurs 1 bit permet de générer le signal OUT_XOR4_b. Le signal OUT_XOR4_b est égal à 0 lorsque les 2 nombres sont égaux. Le signal OUT_XOR4 est l'inverse de OUT_XOR4_b.

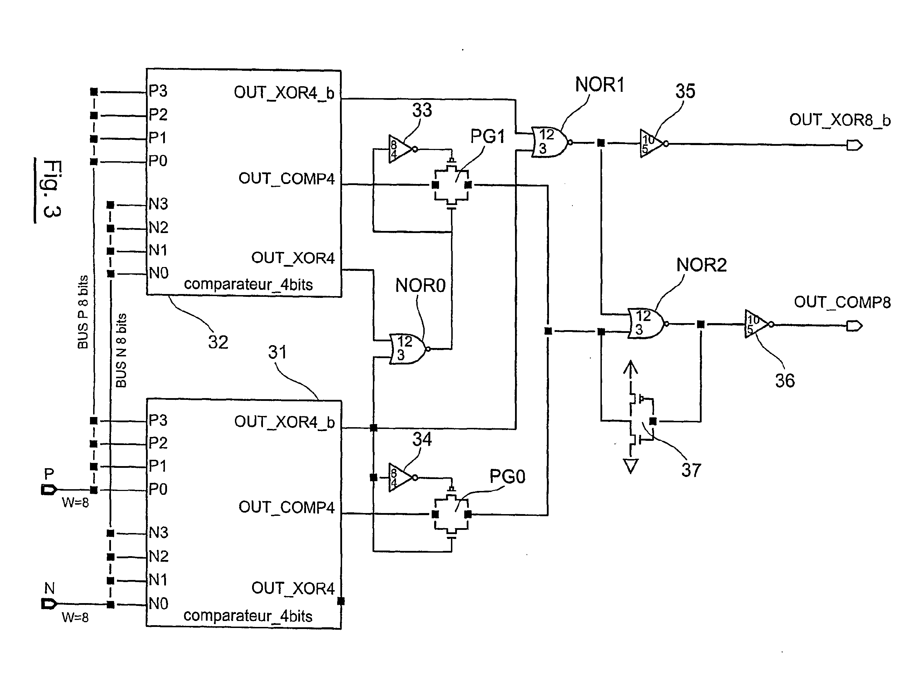

On présente maintenant, en relation avec la **figure 3,** un bloc comparateur 8 bits.

Ce bloc reçoit en entrée un bus d'entrée N de 8 bits et un bus d'entrée P de 8 bits, N et P étant des mots de 8 bits à comparer.

Il présente deux sorties :
- la sortie OUT_XOR8_b, qui est active à 0 et indique si les deux nombres de 8 bits sont égaux ;
- la sortie OUT_COMP8, qui indique le résultat de la comparaison des deux nombres de 8 bits (c'est-à-dire lequel des deux est le plus grand).

Il comprend :
- deux blocs comparateur 4 bits référencés 31 et 32 ;
- trois portes NOR référencées NOR0, NOR1 et NOR2 ;
- quatre inverseurs référencés 33 à 36 ;
- deux portes de passage sélectif référencées PG0 et PG1.

La porte NOR1 et l'inverseur référencé 35 qui la suit forment ensemble une porte OR, recevant en entrée les sorties OUT_XOR4_b des deux blocs comparateur 4 bits. La sortie de cette porte OR constitue la sortie OUT_XOR8_b du bloc comparateur 8 bits.

La sortie OUT_COMP4 du bloc comparateur 4 bits référencé 31, qui traite les bits de poids forts, est reliée à la sortie OUT_COMP8 du bloc comparateur 8 bits via la porte de passage sélectif PG0 (ainsi que via des moyens de mémorisation construits autour de la porte NOR2, comme expliqué ci-après). La porte de passage sélectif PG0 est commandée par la sortie OUT_XOR4_b du bloc comparateur 4 bits référencé 31.

La sortie OUT_COMP4 de l'autre bloc comparateur 4 bits référencé 32 est reliée à la sortie OUT_COMP8 du bloc comparateur 8 bits, via la porte de passage sélectif PG1 (ainsi que via des moyens de mémorisation construits autour de la porte NOR2, comme expliqué ci-après). La porte de passage sélectif PG1 est commandée par un « non OU » (réalisé avec la porte NOR0) de la sortie OUT_XOR4_b du bloc comparateur 4 bits référencé 31 et de la sortie OUT_XOR4 du bloc comparateur 4 bits référencé 32.

On détaille maintenant le fonctionnement de ce bloc comparateur 8 bits. On utilise deux blocs comparateur 4bits fonctionnant en parallèle. Le premier bloc 31 est relié aux quatre bits de poids forts des bus N et P. Le second bloc 32 est relié aux bits de poids faibles des bus N et P. Ainsi les deux blocs 31, 32 fonctionnent totalement en parallèle mais la validation de la sortie du bloc de poids faible 31 dépend de la valeur du signal de sortie OUT_XOR4_b du bloc de poids fort 32.

Si la sortie OUT_XOR4_b du premier bloc comparateur_4bits 31 est égal à 1, alors un des deux nombres de 4 bits est supérieur à l'autre. La valeur du signal OUT_COMP4 du premier bloc 31 indique lequel des deux nombres est le plus grand. La porte de passage PG0 est alors passante, tandis que la porte de passage PG1 est bloquée par la porte NOR0. Le signal OUT_COMP8 donne alors le résultat de la comparaison des 8 bits (il est à 0 si N est supérieur à P).

Si la sortie OUT_XOR4_b du premier bloc comparateur 4 bits 31 est égal à 0, c'est que les quatre bits de poids fort sont identiques, le résultat de la comparaison découlera de la comparaison des 4 bits de poids faibles. Deux cas sont alors possibles.

Premier cas : si le signal OUT_XOR4_b du second bloc 32 est égal à 0, alors les deux nombres sont égaux. Dans ce cas, la porte de passage PG0 est bloquée par le signal OUT_XOR4_b du premier bloc comparateur 4bits 31, tandis que la porte de passage PG1 est bloquée par la NORO. L'entrée de la NOR2 est forcée à 1 par la sortie de la NOR1, celle-ci est égale à 1 lorsque les deux signaux OUT_XOR4_b (des premier et second blocs comparateur 4bits 31 et 32) sont à 0. La sortie OUT_COMP8 est ainsi égale à 1, et d'une manière générale, le signal OUT_COMP8 est égal à 1 lorsque N est inférieur ou égal à P. La sortie OUT_XOR8_b est alors égale à 0. Elle est à 0 chaque fois que les deux nombres N et P sont égaux.

Second cas : si le signal OUT_XOR4_b du second bloc 32 est égal à 1, les deux nombres sont alors différents et la valeur du signal OUT_COMP8 indique lequel des deux nombres est le plus grand (OUT_COMP8 est à 0 si N est supérieur à P). Dans ce cas, l'entrée de la NOR2 est à 0.

Un inverseur de faible dimension (faible courant) 37 rebouclé à la NOR2 permet de mémoriser la valeur de la comparaison à la fin de l'opération.

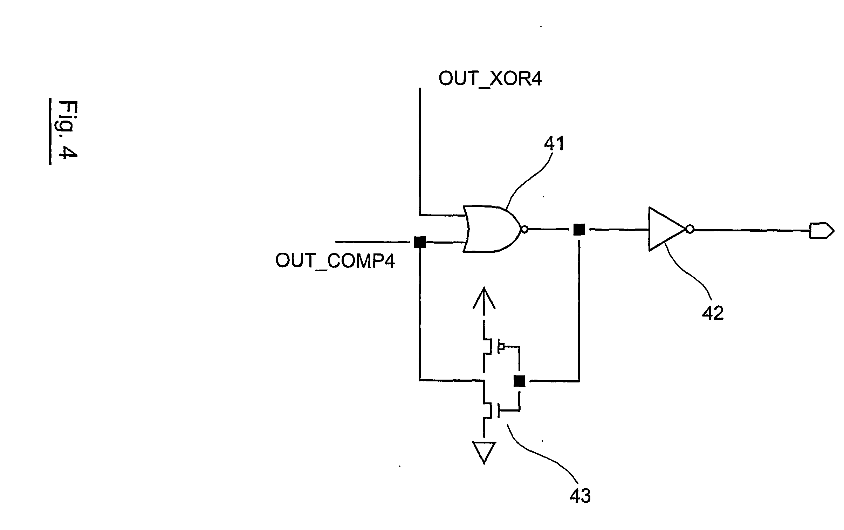

Comme illustré sur la **figure 4,** le bloc comparateur 4 bits peut comprendre des moyens (optionnels) de mémorisation de la valeur présente sur la seconde sortie (OUT_COMP4) du bloc comparateur de niveau 1 (bloc comparateur 4 bits) de la figure 2.

C'est notamment le cas lorsque le bloc comparateur 4 bits est utilisé seul (et non pas dans un bloc comparateur 8 bits comme décrit ci-dessus en relation avec la figure 3).

Une porte NOR 41 reçoit en entrée les sorties OUT_COMP4 et OUT_XOR4 du bloc comparateur 4 bits. Sa sortie est suivie d'un inverseur 42. Un inverseur de faible dimension (faible courant) 43 rebouclé à la porte NOR 41 permet de mémoriser la valeur de la comparaison à la fin de l'opération.

## Revendications

1. Dispositif de comparaison de deux mots N et P de n bits chacun, **caractérisé en ce qu'**il comprend au moins un bloc comparateur de niveau 1 comprenant lui-même :
- n blocs comparateur de base, permettant chacun de comparer les bits Ni et Pi de rang i des mots N et P, avec i compris entre 0 et n-1, et comprenant chacun :
* un premier sous-bloc permettant de générer sur sa sortie, formant une première sortie (OUT_XORi) du bloc comparateur de base, un premier signal indiquant si les bits Ni et Pi sont égaux ou non ;
* un second sous-bloc permettant de générer sur sa sortie un second signal indiquant lequel des bits Ni et Pi est le plus grand ;
* un troisième sous-bloc permettant de laisser passer le second signal sur une seconde sortie (SOUTi) du bloc comparateur de base, si le premier signal n'indique pas une égalité des bits Ni et Pi, et de bloquer le second signal dans le cas contraire ;
- des moyens de génération d'un troisième signal sur une première sortie (OUT_XOR4_b) du bloc comparateur de niveau 1, indiquant que les nombres N et P sont égaux si les n premiers signaux indiquent que les n bits Ni et les n bits Pi sont égaux, et indiquant que les nombres N et P ne sont pas égaux dans le cas contraire ;
- des premiers moyens de passage sélectif, permettant de relier sélectivement à une seconde sortie (OUT_COMP4) du bloc comparateur de niveau 1 la seconde sortie (SOUTi) d'un bloc comparateur de base qui, parmi les blocs comparateurs de base ayant un second signal sur leur seconde sortie, traite des bits de plus fort poids, le signal présent sur la seconde sortie du bloc comparateur de niveau 1 indiquant lequel des nombres N et P est le plus grand.

2. Dispositif selon la revendication 1, **caractérisé en ce que** le premier sous-bloc comprend une porte « OU exclusif » recevant en entrée les bits Ni et Pi.

3. Dispositif selon l'une quelconque des revendications 1 et 2, **caractérisé en ce que** le second sous-bloc comprend une porte « OU » recevant en entrée le bit Pi et, via un inverseur, le bit Ni.

4. Dispositif selon l'une quelconque des revendications 1 à 3, **caractérisé en ce que** le troisième sous-bloc comprend une porte « de passage sélectif » (pass-gate) dont l'entrée est reliée à la sortie du second sous-bloc et qui est commandée par la sortie du premier sous-bloc.

5. Dispositif selon l'une quelconque des revendications 1 à 4, **caractérisé en ce que** les moyens de génération du troisième signal, sur la première sortie (OUT_XOR4_b) du bloc comparateur de niveau 1, comprennent une porte « OU » dont les entrées sont reliées aux premières sorties (OUT_XORi) des blocs comparateur de base.

6. Dispositif selon l'une quelconque des revendications 1 à 5, **caractérisé en ce que** les premiers moyens de passage sélectif comprennent :
- des moyens permettant de relier la seconde sortie (SOUTi) du bloc comparateur de base traitant les bits de poids forts Nn-1 et Pn-1 à la seconde sortie (OUT_COMP4) du bloc comparateur de niveau 1, de façon directe ;
- pour chacun des autres blocs comparateur de base traitant des bits Nj et Pj, avec j compris entre 0 et n-2, des moyens permettant de relier la seconde sortie (SOUTi) du bloc comparateur de base à la seconde sortie (OUT_COMP4) du bloc comparateur de niveau 1, via une porte « de passage sélectif » (pass-gate) commandée par la sortie d'une porte « OU » dont les entrées sont reliées aux premières sorties (OUT_XORi) des blocs comparateur de base de poids supérieur à j.

7. Dispositif selon l'une quelconque des revendications 1 à 6, **caractérisé en ce que** ledit au moins un bloc comparateur de niveau 1 comprend en outre des moyens de mémorisation de la valeur présente sur la seconde sortie (OUT_COMP4) du bloc comparateur de niveau 1.

8. Dispositif selon la revendication 7, **caractérisé en ce que** les moyens de mémorisation comprennent :
- une porte « NON OU » dont une première entrée est reliée à la seconde sortie (OUT_COMP4) du bloc comparateur de niveau 1 et une seconde entrée est reliée, via un inverseur, à la première sortie (OUT_XOR4_b) du bloc comparateur de niveau 1 ;
- un inverseur faible courant reliant la sortie de ladite porte « NON OU » à la première entrée de ladite porte « NON OU ».

9. Dispositif selon l'une quelconque des revendications 1 à 8, **caractérisé en ce qu'**il comprend au moins un bloc comparateur de niveau 2 comprenant lui-même :
- q blocs comparateur de niveau 1, avec q ≥ 2, comprenant chacun une partie des n blocs comparateur de base ;
- des moyens de génération d'un quatrième signal sur une première sortie (OUT_XOR8_b) du bloc comparateur de niveau 2, indiquant que les nombres N et P sont égaux si les premières sorties (OUT_XOR4_b) des q blocs comparateur de niveau 1 indiquent que les bits qu'ils comparent sont égaux, et indiquant que les nombres N et P ne sont pas égaux dans le cas contraire ;
- des seconds moyens de passage sélectif, permettant de relier sélectivement à une seconde sortie (OUT_COMP8) du bloc comparateur de niveau 2 la seconde sortie (OUT_COMP4) d'un bloc comparateur de niveau 1 qui, parmi les blocs comparateurs de niveau 1 ayant un second signal sur leur seconde sortie, traite des bits de plus fort poids, le signal présent sur la seconde sortie du bloc comparateur de niveau 2 indiquant lequel des nombres N et P est le plus grand.

10. Dispositif selon la revendication 9, **caractérisé en ce que** les moyens de génération du quatrième signal, sur la première sortie (OUT_XOR8_b) du bloc comparateur de niveau 2, comprennent une porte « OU » dont les entrées sont reliées aux premières sorties (OUT_XOR4_b) des blocs comparateur de niveau 1.

11. Dispositif selon l'une quelconque des revendications 9 et 10, **caractérisé en ce que** les seconds moyens de passage sélectif comprennent :
- des moyens permettant de relier la seconde sortie (OUT_COMP4) du bloc comparateur de niveau 1 traitant les bits de poids forts à la seconde sortie (OUT_COMP8) du bloc comparateur de niveau 2, via une porte « de passage sélectif » (pass-gate) commandée par la première sortie (OUT_XOR4_b) du bloc comparateur de niveau 1 traitant les bits de poids forts ;
- pour chacun des autres blocs comparateur de niveau 1, des moyens permettant de relier la seconde sortie (OUT_COMP4) du bloc comparateur de niveau 1 à la seconde sortie (OUT_COMP8) du bloc comparateur de niveau 2, via une porte « de passage sélectif » (pass-gate) commandée par la sortie d'une porte « OU » dont une entrée est reliée, via un inverseur, à la première sortie (OUT_XOR4_b) dudit bloc comparateur de niveau 1, et dont les autres entrées sont reliées aux premières sorties (OUT_XOR4_b) des blocs comparateur de niveau 1 de poids supérieur.

12. Dispositif selon l'une quelconque des revendications 9 à 11, **caractérisé en ce que** ledit au moins un bloc comparateur de niveau 2 comprend en outre des moyens de mémorisation de la valeur présente sur la seconde sortie (OUT_COMP8) du bloc comparateur de niveau 2.

13. Dispositif selon la revendication 12, **caractérisé en ce que** les moyens de mémorisation comprennent :
- une porte «NON OU » dont une première entrée est reliée à la seconde sortie (OUT_COMP8) du bloc comparateur de niveau 2 et une seconde entrée est reliée, via un inverseur, à la première sortie (OUT_XOR8_b) du bloc comparateur de niveau 2 ;
- un inverseur faible courant reliant la sortie de ladite porte « NON OU » à la première entrée de ladite porte « NON OU ».

14. Dispositif selon l'une quelconque des revendications 1 à 13, **caractérisé en ce qu'**il comprend au moins un bloc comparateur de niveau k, avec k ≥ 2, comprenant lui-même :
- p blocs comparateur de niveau k-1, avec p ≥ 2 ;
- des moyens de génération d'un cinquième signal sur une première sortie du bloc comparateur de niveau k, indiquant que les nombres N et P sont égaux si des premières sorties des p blocs comparateur de niveau k-1 indiquent que les bits qu'ils comparent sont égaux, et indiquant que les nombres N et P ne sont pas égaux dans le cas contraire;
- des troisièmes moyens de passage sélectif, permettant de relier sélectivement à une seconde sortie du bloc comparateur de niveau k la seconde sortie d'un bloc comparateur de niveau k-1 qui, parmi les blocs comparateurs de niveau k-1 ayant un signal sur leur seconde sortie, traite des bits de plus fort poids, le signal présent sur la seconde sortie du bloc comparateur de niveau k indiquant lequel des nombres N et P est le plus grand.

15. Dispositif selon l'une quelconque des revendications 1 à 14, **caractérisé en ce que** chaque porte « de passage sélectif » (pass-gate) comprend un transistor N monté en parallèle avec un transistor P.

16. Dispositif selon l'une quelconque des revendications 1 à 15, **caractérisé en ce qu'**il est réalisé sous la forme d'un circuit câblé.

## Claims

1. Device for comparing two words N and P of n bits each, **characterised in that** it includes at least one level-1 comparator block which itself includes:
- n basic comparator blocks, each enabling the bits Ni and Pi of position i of words N and P to be compared, with i being between 0 and n-1, and each including:
* a first sub-block for generating at its output, forming a first output (OUT_XORi) of the basic comparator block, a first signal indicating whether or not the bits Ni and Pi are equal;
* a second sub-block enabling a second signal, indicating which of the bits Ni and Pi is greater, to be generated at its output;
* a third sub-block enabling the second signal to pass to a second output (SOUTi) of the basic comparator block, if the first signal does not indicate an equality of the bits Ni and Pi, and otherwise enabling the second signal to be blocked;
- means for generating a third signal at a first output (OUT_XOR4_b) of the level-1 comparator block, indicating that the numbers N and P are equal if the n first signals indicate that the n bits Ni and the n bits Pi are equal, and otherwise indicating that the numbers N and P are not equal;
- first selective passage means enabling the second output (SOUTi) of a basic comparator block to be selectively connected to a second output (OUT_COMP4) of the level-1 comparator block, which basic comparator block, from among the basic comparator blocks having a second signal at their second output, processes higher-order bits, with the signal present at the second output of the level-1 comparator block indicating which of the numbers N and P is greater.

2. Device according to claim 1, **characterised in that** the first sub-block includes an "exclusive-OR" gate receiving the bits Ni and Pi at the input.

3. Device according to claim 1 or 2, **characterised in that** the second sub-block includes an "OR" gate receiving, at the input, the bit Pi and, via an inverter, the bit Ni.

4. Device according to any of the claims 1 to 3, **characterised in that** the third sub-block includes a "selective passage" gate of which the input is connected to the output of the second sub-block and which is controlled by the output of the first sub-block.

5. Device according to any of the claims 1 to 4, **characterised in that** the means for generating the third signal, at the first output (OUT_XOR4_b) of the level-1 comparator block, include an "OR" gate of which the inputs are connected to the first outputs (OUT_XORi) of the basic comparator blocks.

6. Device according to any of the claims 1 to 5, **characterised in that** the first selective passage means include:
- means enabling the second output (SOUTi) of the basic comparator block processing the high-order bits Nn-1 and Pn-1 to be directly connected to the second output (OUT_COMP4) of the level-1 comparator block;
- for each of the other basic comparator blocks processing Nj and Pj bits, with j being between 0 and n-2, means for connecting the second output (SOUTi) of the basic comparator block to the second output (OUT_COMP4) of the level-1 comparator block, via a "selective passage" gate (pass-gate) controlled by the output of an "OR" gate of which one inputs are connected to the first outputs (OUT_XORi) of the basic comparator blocks of higher order than j.

7. Device according to any of the claims 1 to 6, **characterised in that** said at least one level-1 comparator block also includes means for storing the value present at the second output (OUT_COMP4) of the level-1 comparator block.

8. Device according to claim 7, **characterised in that** the storage means include:
- a "NOT OR" gate of which a first input is connected to the second output (OUT_COMP4) of the level-1 comparator block and a second input is connected, via an inverter, to the first output (OUT_XOR4_b) of the level-1 comparator block;
- a low-current inverter connecting the output of said "NOT OR" gate to the first input of said "NOT OR" gate.

9. Device according to any of the claims 1 to 8, **characterised in that** it includes at least one level-2 comparator block which itself includes:
- q level-1 comparator blocks, with q ≥ 2, each including a portion of the n basic comparator blocks;
- means for generating a fourth signal at a first output (OUT_XOR8_b) of the level-2 comparator block, indicating that the numbers N and P are equal if the first outputs (OUT_XOR4_b) of the q level-1 comparator blocks indicate that the bits that they compare are equal, and otherwise indicating that the numbers N and P are not equal;
- second selective passage means, enabling the second output (OUT_COMP4) of a level-1 comparator block to be selectively connected to a second output (OUT_COMP8) of the level-2 comparator block, which level-1 comparator block, from among the level-1 comparator blocks having a second signal at their second output, processes higher-order bits, with the signal present at the second output of the level-2 comparator block indicating which of the numbers N and P is greater.

10. Device according to claim 9, **characterised in that** the means for generating the fourth signal, at the first output of the level-2 comparator block, include an "OR" gate of which the inputs are connected o the first outputs of the level-1 comparator blocks.

11. Device according to claim 9 or 10, **characterised in that** the second selective passage means include:
- means enabling the second output (OUT_COMP4) of the level-1 comparator block processing the high-order bits to be connected to the second output (OUT_COMP8) of the level-2 comparator block, via a "selective passage" gate controlled by the first output (OUT_XOR4_b) of the level-1 comparator block processing the high-order bits;
- for each of the other level-1 comparator blocks, means for connecting the second output (OUT_COMP4) of the level-1 comparator block to the second output (OUT_COMP8) of the level-2 comparator block, via a "selective passage" gate controlled by the output of an "OR" gate of which one input is connected, via an inverter, to the first output (OUT_XOR4_b) of said level-1 comparator block, and of which the other inputs are connected to the first outputs (OUT_XOR4_b) of the higher-order level-1 comparator blocks.

12. Device according to any of the claims 9 to 11, **characterised in that** said at least one level-2 comparator block also includes means for storing the value present at the second output (OUT_COMP8) of the level-2 comparator block.

13. Device according to claim 12, **characterised in that** the storage means include:
- a "NOT OR" gate of which a first input is connected to the second output (OUT_COMP8) of the level-2 comparator block and a second input is connected, via an inverter, to the first output (OUT_XOR8_b) of the level-2 comparator block;
- a low-current inverter connecting the output of said "NOT OR" gate to the first input of said "NOT OR" gate.

14. Device according to any of the claims 1 to 13, **characterised in that** it includes at least one level-k comparator block, with k ≥ 2, which itself includes:
- p level-k-1 comparator blocks, with p ≥ 2;
- means for generating a fifth signal at a first output of the level-k comparator block, indicating that the numbers N and P are equal if the first outputs of p level-k-1 comparator blocks indicate that the bits that they are comparing are equal, and otherwise indicating that the numbers N and P are not equal;
- third selective passage means, enabling the second output of a level-k-1 comparator block to be selectively connected to a second output of the level-k comparator block, which level-k-1 comparator block, from among the level-k-1 comparator blocks having a signal at their second output, processes higher-order bits, with the signal present at the second output of the level-k comparator block indicating which of the numbers N and P is greater.

15. Device according to any of the claims 1 to 14, **characterised in that** each selective passage gate includes a transistor N mounted parallel with respect to a transistor P.

16. Device according to any of the claims 1 to 15, **characterised in that** it is produced in the form of a wired circuit.

## Patentansprüche

1. Vorrichtung zum Vergleichen zweier Wörter N und P von jeweils n Bits,
**dadurch gekennzeichnet, dass** sie mindestens einen Vergleicherblock der Ebene 1 umfasst, die selbst folgendes umfasst:
- n Basisvergleicherblöcke, von denen jeder den Vergleich der Bits Ni und Pi des Ranges 1 der Wörter N und P ermöglicht, wobei i zwischen 0 und n-1 liegt und von denen jeder folgendes umfasst:
* einen ersten Unterblock, der es ermöglicht, an seinem Ausgang, der einen ersten Ausgang (OUT_XORi) des Basisvergleicherblocks bildet, ein erstes Signal zu erzeugen, das angibt, ob die Bits Ni und Pi gleich sind oder nicht;
* einen zweiten Unterblock, der es ermöglicht, an seinem Ausgang ein zweites Signal zu erzeugen, welches angibt, welches der Bits Ni und Pi größer ist;
* einen dritten Unterblock, der es ermöglicht, das zweite Signal über einen zweiten Ausgang (SOUTi) des Basisvergleicherblocks durchzulassen, wenn das erste Signal keine Gleichheit der Bits Ni und Pi angibt, und dieses zweite Signal andernfalls zu blockieren;
- Mittel zum Erzeugen eines dritten Signals an einem ersten Ausgang (OUT_XOR4_b) des Vergleicherblocks der Ebene 1, die angeben, dass die Zahlen N und P gleich sind, wenn die n ersten Signale angeben, dass die n Bits von Ni und die n Bits von Pi gleich sind und dass die Zahlen N und P andernfalls nicht gleich sind;
- erste Mittel für den selektiven Durchgang, die es ermöglichen, einen zweiten Ausgang (OUT_COMP4) des Vergleicherblocks der Ebene 1 mit dem zweiten Ausgang (SOUTi) eines Basisvergleicherblocks zu verbinden, wobei dieser Basisvergleicherblock unter den Basisvergleicherblöcken, die ein zweites Signal an ihrem zweiten Ausgang aufweisen, Bits höheren Gewichts verarbeitet, wobei das am zweiten Ausgang des Vergleicherblocks der Ebene 1 vorhandene Signal angibt, welche der Zahlen N und P die größere ist.

2. Vorrichtung nach Anspruch 1, **dadurch gekennzeichnet, dass** der erste Unterblock ein "exklusives ODER" Gatter aufweist, das die Bits Ni und Pi am Eingang empfängt.

3. Vorrichtung nach einem der Ansprüche 1 oder 2, **dadurch gekennzeichnet, dass** der zweite Unterblock ein "ODER" Gatter aufweist, das am Eingang den Bit Pi und den Bit Ni über einen Inverter empfängt.

4. Vorrichtung nach einem der Ansprüche 1 bis 3, **dadurch gekennzeichnet, dass** der dritte Unterblock ein "selektives Durchgangsgatter" (pass-gate) aufweist, dessen Eingang mit dem Ausgang des zweiten Unterblocks verbunden ist und vom Ausgang des ersten Unterblocks gesteuert wird.

5. Vorrichtung nach einem der Ansprüche 1 bis 4, **dadurch gekennzeichnet, dass** die Mittel zum Erzeugen des dritten Signals am ersten Ausgang (OUT_XOR4_b) des Vergleicherblocks der Ebene 1 ein "ODER" Gatter aufweisen, dessen Eingänge mit den ersten Ausgängen (OUT_ XORi) der Basisvergleicherblöcke verbunden sind.

6. Vorrichtung nach einem der Ansprüche 1 bis 5, **dadurch gekennzeichnet, dass** die ersten selektiven Durchgangsmittel folgendes umfassen:
- Mittel, die das Verbinden des zweiten Ausgangs (SOUTi) des die stark gewichteten Bits Nn-1 verarbeitenden Basisvergleicherblöcke mit dem zweiten Ausgang (OUT_COMP4) des Vergleicherblocks der Ebene 1 in direkter Weise ermöglichen;
- für jeden der anderen Basisvergleicherblöcke, welche Bits Nj und Pj verarbeiten, wobei j zwischen 0 und n-2 liegt, Mittel die das Verbinden des zweiten Ausgangs (SOUTi) des Basisvergleicherblocks mit dem zweiten Ausgang (OUT_COMP4) des Vergleicherblocks der Ebene 1 über ein "selektives Durchgangsgatter" (pass-gate) ermöglichen, wobei dieses Gatter vom Ausgang eines "ODER" Gatters gesteuert wird, dessen Eingänge mit den ersten Ausgängen (OUT_XORi) der Basisvergleicherblöcke mit einem stärkeren Gewicht als j verbunden sind.

7. Vorrichtung nach einem der Ansprüche 1 bis 6, **dadurch gekennzeichnet, dass** der mindestens eine Vergleicherblock der Ebene 1 darüber hinaus Mittel zum Speichern des am zweiten Ausgang (OUT_COMP4) des Vergleicherblocks der Ebene 1 vorhandenen Wertes aufweist.

8. Vorrichtung nach Anspruch 7, **dadurch gekennzeichnet, dass** die Speichermittel folgendes umfassen:
- ein "NEIN ODER" Gatter, dessen erster Eingang mit dem zweiten Ausgang (OUT-COMP4) des Vergleicherblocks der Ebene 1 verbunden ist und von dem ein zweiter Eingang über einen Inverter mit dem ersten Ausgang (OUT_XORb) des Vergleicherblocks der Ebene 1 verbunden ist;
- einen Schwachstrom-Inverter, der den Ausgang des besagten "NEIN ODER" Gatters mit dem ersten Eingang des "NEIN ODER" Gatters verbindet.

9. Vorrichtung nach einem der Ansprüche 1 bis 8, **dadurch gekennzeichnet, dass** sie mindestens einen Vergleicherblock der Ebene 2 aufweist, der selbst folgendes umfasst:
- q Vergleicherblöcke der Ebene 1 mit q ≥ 2, die jeweils einen Teil der n Basisvergleicherblöcke enthalten;
- Mittel zum Erzeugen eines vierten Signals an einem ersten Ausgang (OUT_XOR8_b) des Vergleicherblocks der Ebene 2, das angibt, ob die Zahlen N und P gleich sind, wenn die ersten Ausgänge (OUT_XOR4_b) der q Verteilerblöcke der Ebene 1 angeben, dass die Bits, die sie vergleichen, gleich sind und dass die Zahlen N und P andernfalls nicht gleich sind;
- zweite selektive Durchgangsmittel, die das selektive Verbinden eines zweiten Ausgangs (OUT_COMP8) des Vergleicherblocks der Ebene 2 mit dem zweiten Ausgang (OUT_COMP4) eines Vergleicherblocks der Ebene 1 ermöglichen, der unter den Vergleicherblöcken der Ebene 1, welche ein zweites Signal an ihrem zweiten Ausgang aufweisen, höher gewichtete Bits verarbeitet, wobei das am zweiten Ausgang des Vergleicherblocks der Ebene 2 vorhandene Signal angibt, welche der Zahlen N und P die größere ist.

10. Vorrichtung nach Anspruch 9, **dadurch gekennzeichnet, dass** die Mittel zum Erzeugen des vierten Signals am ersten Ausgang (OUT_XOR8_b) des Vergleicherblocks der Ebene 2 ein "ODER" Gatter aufweisen, dessen Eingänge mit den ersten Ausgängen (OUT_XOR4_b) des Vergleicherblocks der Ebene 1 verbunden sind.

11. Vorrichtung nach einem der Ansprüche 9 oder 10, **dadurch gekennzeichnet, dass** die zweiten selektiven Durchgangsmittel folgendes umfassen:
- Mittel, die das Verbinden des stark gewichtete Bits verarbeitenden zweiten Ausgangs (OUT_COMP4) des Vergleicherblocks der Ebene 1 mit dem zweiten Ausgang (OUT_COMP8) des Vergleicherblocks der Ebene 2 über ein "selektives Durchgangsgatter" (pass-gate) ermöglichen, wobei dieses Gatter vom ersten Ausgang (OUT_XOR4_b) des stark gewichtete Bits verarbeitenden Vergleicherblocks der Ebene 1 gesteuert wird;
- für jeden der anderen Vergleicherblöcke der Ebene 1, Mittel, die das Verbinden des zweiten Ausgangs (OUT_COMP4) des Vergleicherblocks der Ebene 1 mit dem zweiten Ausgang (OUT_COMP8) des Vergleicherblocks der Ebene 2 über ein "selektives Durchgangsgatter" (pass-gate) ermöglicht, wobei dieses Gatter vom Ausgang eines "ODER" Gatters gesteuert wird, dessen einer Eingang über einen Inverter mit dem ersten Ausgang (OUT_XOR4_b) des besagten Vergleicherblocks der Ebene 1 verbunden ist und dessen andere Eingänge mit den ersten Ausgängen (OUT_XOR4_b) der höher gewichteten Vergleicherblöcke der Ebene 1 verbunden sind.

12. Vorrichtung nach einem der Ansprüche 9 bis 11, **dadurch gekennzeichnet, dass** der besagte mindestens eine Vergleicherblock der Ebene 2 ferner Mittel zum Speichern des am zweiten Ausgang (OUT_COMP8) des Vergleicherblocks der Ebene 2 vorhandenen Wertes aufweist.

13. Vorrichtung nach Anspruch 12, **dadurch gekennzeichnet, dass** die Speichermittel folgendes umfassen:
- ein "NEIN ODER" Gatter, von dem ein erster Eingang mit dem zweiten Ausgang (OUT_COMP8) des Vergleicherblocks der Ebene 2 verbunden ist, während ein zweiter Eingang über einen Inverter mit dem ersten Ausgang (OUT_XOR8_b) des Vergleicherblocks der Ebene 2 verbunden ist;
- einen Schwachstrom-Inverter, der den Ausgang des besagten "NEIN ODER" Gatters mit dem ersten Eingang dieses "NEIN ODER" Gatters verbindet.

14. Vorrichtung nach einem der Ansprüche 1 bis 13, **dadurch gekennzeichnet, dass** sie mindestens einen Vergleicherblock der Ebene k, mit k ≥ 2 aufweist, der selbst folgendes umfasst:
- p Vergleicherblöcke der Ebene k-1 mit p ≥ 2;
- Mittel zum Erzeugen eines fünften Signals an einem ersten Ausgang des Vergleicherblocks der Ebene k, die angeben, dass die Zahlen P und N gleich sind, wenn erste Ausgänge der p Vergleicherblöcke der Ebene k-1 angeben, dass die von ihnen verglichenen Bits gleich sind und dass die Zahlen N und P andernfalls nicht gleich sind;
- dritte selektive Durchgangsmittel, die das selektive Verbinden eines zweiten Ausgangs des Vergleicherblocks der Ebene k mit dem zweiten Ausgang eines Vergleicherblocks der Ebene k-1 ermöglichen, der unter den Vergleicherblöcken der Ebene k-1, welche ein Signal an ihrem zweiten Ausgang aufweisen, höher gewichtete Bits verarbeitet, wobei das am zweiten Ausgang des Vergleicherblocks der Ebene k vorhandene Signal angibt, welche der Zahlen N und P die größere ist.

15. Vorrichtung nach einem der Ansprüche 1 bis 14, **dadurch gekennzeichnet, dass** jedes "selektive Durchgangsgatter" (pass-gate) einen Transistor N aufweist, der parallel zu einem Transistor P geschaltet ist.

16. Vorrichtung nach einem der Ansprüche 1 bis 15, **dadurch gekennzeichnet, dass** sie in Form eines verdrahteten Kreislaufs ausgeführt ist.
